# EUROPÄISCHE PATENTANMELDUNG

(11) **EP 1 391 992 A1**
(43) Veröffentlichungstag der Anmeldung: **25.02.2004**
(21) Anmeldenummer: 02018602.9
(22) Anmeldetag: 19.08.2002
(51) Int. Cl.: H03M 1/00

(54) **Anordnung zur Digital-Analog-Wandlung eines hochfrequenten digitalen Eingangssignals in ein trägerfrequentes analoges Ausgangssignal**

(71) Anmelder: SIEMENS AKTIENGESELLSCHAFT, 80333 München (DE)
(72) Erfinder: Fuchs, Armin, Dr., 73326 Deggingen (DE); Jelonnek, Björn, Dr., 89079 Ulm (DE); Wolff, Gunter, Dr., 89081 Ulm (DE)

(57) **Zusammenfassung**

Die Anordnung zur Digital-Analog-Wandlung weist eine Verzögerungseinrichtung mit mindestens einem ersten Verzögerungsglied auf, wobei gegebenenfalls weitere Verzögerungsglieder dem ersten seriell aufeinanderfolgend nachgeschaltet sind. Das digitale Eingangssignal ist einerseits an einen Eingang des ersten Verzögerungsglieds und andererseits an einen Eingang eines ersten D/A-Wandlers angeschaltet. Das erste Verzögerungsglied ist ausgangsseitig mit einem Eingang eines ihm zugeordneten weiteren D/A-Wandlers verbunden. Die gegebenenfalls weiteren Verzögerungsglieder sind jeweils ausgangsseitig mit einem Eingang eines dem jeweiligen Verzögerungsglied zugeordneten weiteren D/A-Wandlers verbunden. Alle D/A-Wandler werden ausgangsseitig stufenweise derart zusammengefasst sind, dass Ausgangssignale aller D/A-Wandler das analoge Ausgangssignal bilden. Jedem D/A-Wandler wird ein spezifischer Koeffizient und jedem Verzögerungsglied wird eine spezifische Verzögerungszeit derart zugeordnet, dass eine Filtercharakteristik realisiert wird.

## Beschreibung

Die Erfindung betrifft eine Anordnung zur Digital-Analog-Wandlung eines hochfrequenten digitalen Eingangssignals in ein trägerfrequentes analoges Ausgangssignal.

Es sind Architekturen zur Erzeugung eines breitbandigen, trägerfrequenten Ausgangssignals bekannt, bei denen in einem niedrigen Frequenzbereich ein digitales Eingangssignal mit Hilfe eines Digital-Analog-Wandlers in ein analoges Signal gewandelt und anschließend mit Hilfe einer oder mehrerer Mischerstufen in das trägerfrequente Ausgangssignal umgesetzt wird.

Weiterhin sind Digital-Analog-Wandler-Architekturen bekannt, bei denen aus einem hochfrequenten digitalen Eingangssignal ohne weitere Frequenzumsetzung ein trägerfrequentes Ausgangssignal erzeugt wird. Das trägerfrequente analoge Ausgangssignal weist dabei neben einer gewünschten Trägerfrequenz auch unerwünschte Trägerfrequenzen auf, die beispielsweise durch ein nichtideales digitales Eingangssignal bzw. durch verschiedene unerwünschte Modulationsmechanismen entstehen können.

Bei den beschriebenen Architekturen sind stets ausgangsseitig angeordnete, kostenintensive Filter mit einer hohen Güte bzw. Mischer mit einer hohen Linearität notwendig, die jeweils auf einen gewünschten Trägerfrequenzbereich abzustimmen sind. Bei einem gewünschten Wechsel des Trägerfrequenzbereichs müssen diese kostenaufwändig ausgetauscht werden.

Es ist daher Aufgabe der vorliegenden Erfindung, eine Anordnung zur Digital-Analog-Wandlung derart auszubilden, dass sie ohne großen Aufwand auf verschiedenen Trägerfrequenzbereiche abstimmbar ist.

Die Aufgabe der Erfindung wird durch die Merkmale des Anspruchs 1 gelöst. Vorteilhafte Weiterbildungen der Erfindung sind in den Unteransprüchen angegeben.

Die erfindungsgemäße Anordnung zur Digital-Analog-Wandlung weist eine integrierte Filtercharakteristik auf, wodurch ausgangsseitig kostenintensive Mischer bzw. Filter eingespart werden.

Sie besteht aus mehreren, parallel zueinander angeordneten D/A-Wandlern, wobei den einzelnen D/A-Wandlern jeweils spezifische Koeffizienten zugeordnet sind. Dadurch wird eine optimale Anpassung an einen gewünschten Trägerfrequenzbereich ermöglicht.

Die erfindungsgemäße Anordnung ist auf verschiedene Trägerfrequenzbereiche abstimmbar, indem die Taktfrequenz der D/A-Wandler entsprechend geändert wird.

Erfindungsgemäß wird durch Wahl der den D/A-Wandlern spezifisch zugeordneten Koeffizienten und der den Verzögerungsgliedern spezifisch zugeordneten Verzögerungszeiten besonders bevorzugt eine FIR-Filtercharakteristik realisiert bzw. in der Anordnung integriert. Die aufeinanderfolgenden Koeffizienten entsprechen einer Abtastung einer Impulsantwort von einem Filter, das eine gewünschte Filtercharakteristik aufweist. Dadurch weist das trägerfrequente Ausgangssignal vergleichend zu einer Realisierungsform ohne Filtercharakteristik eine höhere spektrale Reinheit auf.

Die erfindungsgemäß integrierte FIR-Filtercharkteristik ist mit Hilfe einer Taktfrequenz eines Taktsignals skalierbar. Diese kann von der Taktfrequenz der A/D-Wandler abgeleitet oder mit ihr identisch sein. Da sich die Taktfrequenz meist proportional mit der Trägerfrequenz ändert, erfolgt bei der vorliegenden Erfindung die Anpassung der Filtercharakteristik automatisch.

Bei einer Änderung des gewünschten Trägerfrequenzbereichs wird die FIR-Filtercharkterisitik über die Taktfrequenz entsprechend neu eingestellt. Ein Austausch von Hardware-Komponenten entfällt.

Entsprechen die Genauigkeit und die Anzahl der FIR-Filterkoeffizienten den Anforderungen eines neuen Mobilfunkstandards, so ist ein direktes Umschalten des Frequenzbereiches über die Taktfrequenz möglich, wobei das Umschalten mit Hilfe von Software realisierbar wäre.

Die erfindungsgemäße Anordnung ermöglicht für beliebige Trägerfrequenzbereiche, den Filteraufwand durch Vorfilterung erheblich zu minimieren. Zusammen mit einer entsprechenden Leistungsendstufe wird ein senderseitiger Verzicht auf frequenzspezifische Filter hoher Güte ermöglicht.

Mit Hilfe der erfindungsgemäßen Anordnung ist insbesondere ein durch ΣΔ-Wandler geformtes Quantisierungsrauschen des Eingangssignals leicht zu unterdrücken.

Die Filterfunktion der erfindungsgemäßen Anordnung ist durch die Signalform, die jeder D/A-Wandler pro Datum oder Bit ausgibt, beeinflussbar. Mit Hilfe einer geeigneten Signalform, wie beispielsweise Mehrfachpulsen, die aus mehreren Pulsen pro Datum bestehen, ist die Filterfunktion gezielt zu verbessern.

Im Folgenden wird ein Ausführungsbeispiel der Erfindung anhand einer Zeichnung näher erläutert. Dabei zeigt:
- FIG 1: ein Blockschaltbild einer erfindungsgemäßen Anordnung zur Digital-Analog-Wandlung, und
- FIG 2: vergleichend mit FIG 1 ein Ausführungsbeispiel einer erfindungsgemäßen Anordnung zur Digital-Analog-Wandlung.

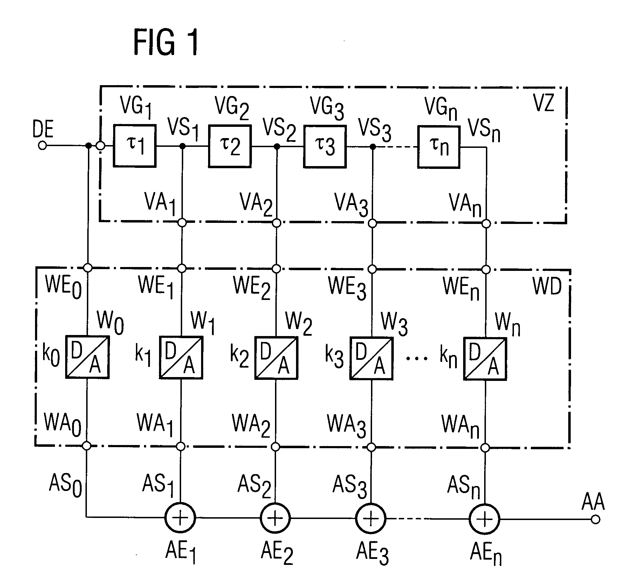

FIG 1 zeigt ein Blockschaltbild einer erfindungsgemäßen Anordnung zur Digital-Analog-Wandlung.

Ein hochfrequentes digitales Eingangssignal DE gelangt einerseits an eine Verzögerungseinrichtung VZ und andererseits an eine Wandlungseinrichtung WD.

Die Verzögerungseinrichtung VZ weist n seriell aneinandergeschaltete Verzögerungsglieder VG1, VG2, VG3, ..., VGn auf, denen jeweils eine spezifische Verzögerungszeit τ1, τ2, τ3, ..., τn zugeordnet ist. Jedes einzelne der Verzögerungsglieder VG1 bis VGn ist ausgangsseitig mit jeweils einem Ausgang VA1, VA2, VA3, ..., VAn der Verzögerungseinrichtung VZ verbunden. Über jeden dieser Ausgänge VA1 bis VAn gelangt ein diesem jeweils zugeordnetes, vom jeweiligen Verzögerungsglied VG1 bis VGn gebildetes Verzögerungssignal VS1, VS2, VS3, ..., VSn an jeweils einen Eingang WE1, WE2, WE3, ..., WEn der Wandlungseinrichtung WD.

Die Wandlungseinrichtung WD weist insgesamt n+1 D/A-Wandler W0, W1, ..., Wn auf, die zueinander parallel angeordnet sind.

Ein erster D/A-Wandler W0 erhält als Eingangssignal das digitale Eingangssignal DE über einen Eingang WE0 der Wandlungseinrichtung WD. Die anderen n D/A-Wandler erhalten über entsprechend zugeordneten Eingänge WE1 bis WEn die Verzögerungssignale VS1 bis VSn als Eingangssignal.

Jedem einzelnen der n+1 D/A-Wandler WE0 bis WEn der Wandlungseinrichtung WD ist jeweils ein spezifischer Koeffizient k0, k1, ..., kn zugeordnet.

Die einzelnen D/A-Wandler W0 bis Wn sind ausgangsseitig, beispielsweise mit Hilfe von n Addiereinrichtungen AE1, AE2, ..., AEn, zusammengefasst. Mit Hilfe der Addiereinrichtungen AE1 bis AEn werden n+1 Ausgangssignale AS0, AS1, ..., ASn der n+1 D/A-Wandler zu einem trägerfrequenten analogen Ausgangssignal AA addiert.

Zu beachten ist, dass die digitalen Eingangssignale DE und VS1 bis VSn bei der D/A-Wandlung in den jeweiligen D/A-Wandlern W0 bis Wn mit den jeweils zugeordneten Koeffizienten k0 bis kn gewichtet werden.

Diese Koeffizienten k0 bis kn der D/A-Wandler W0 bis Wn und die Verzögerungszeiten τ1 bis τn der Verzögerungsglieder VG1 bis VGn werden dabei derart festgelegt, dass die erfindungsgemäße Anordnung zur Digital-Analog-Wandlung eine gewünschte FIR-Filtercharakteristik aufweist.

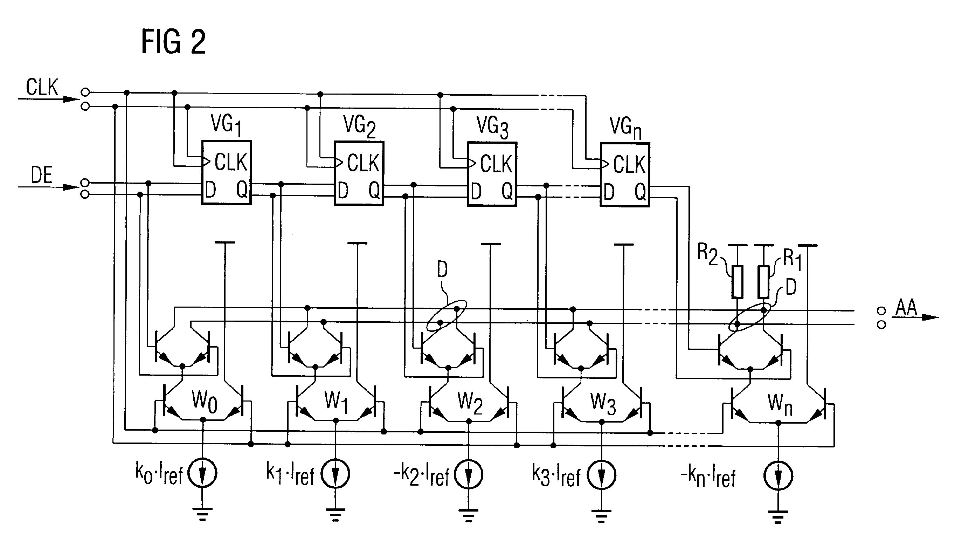

FIG 2 zeigt vergleichend mit FIG 1 ein Ausführungsbeispiel einer erfindungsgemäßen Anordnung zur Digital-Analog-Wandlung.

Die einzelnen D/A-Wandler W0 bis Wn sind als 1Bit-D/A-Wandler und die Verzögerungsglieder VG1 bis VGn als D-Latch realisiert. Sowohl die D/A-Wandler W0 bis Wn als auch die Verzögerungsglieder VG1 bis VGn sind mit einem Taktsignal CLK getaktet.

Am D-Eingang eines ersten D-Latch bzw. eines ersten Verzögerungsglieds VG1 ist das digitale Eingangssignal DE angeschaltet. Ausgangsseitig ist das erste Verzögerungsglied VG1 über seinen Q-Ausgang mit einem D-Eingang des nächsten Verzögerungsglieds VG2 verbunden, usw.

Durch das Taktsignal CLK entsprechen die den einzelnen Verzögerungsgliedern VG1 bis VGn zugeordneten spezifischen Verzögerungszeiten τ1 bis τn, wie hier dargestellt, einer halben Taktperiode des Taktsignals CLK, das ebenfalls an den D/A-Wandlern W0 bis Wn anliegt. Jedes einzelne Verzögerungsglied bzw. D-Latch verzögert um jeweils eine halbe Taktperiode.

Für die Verzögerungsglieder VG1 bis VGn sind jedoch auch kleinere Teile der Taktperiode des Taktsignals CLK verwendbar. Dadurch wird eine feinere Anpassung an eine Impulsantwort einer gewünschten Filtercharakteristik ermöglicht. Dadurch wird wiederum die Nyquistfrequenz der Filtercharakteristik vervielfacht und der Alias-Effekt unterdrückt.

Die jeweils den einzelnen D/A-Wandlern W0 bis Wn zugeordneten Koeffizienten k0 bis kn werden mit Hilfe von Referenzstromquellen kᵢ*Iref (mit i=0 bis n) eingestellt, die die Größe der Ausgangssignale AS0 bis ASn bestimmen.

Sind zur Realisierung der FIR-Filtercharakteristik negative Faktoren bei den Koeffizienten k0 bis kn erforderlich, so werden entsprechende Ausgänge bei den betroffenen D/A-Wandlern vertauscht.

Beispielhaft ist dies für die Koeffizienten k2 und kn gezeigt. Vergleichend mit dem D/A-Wandler W1 wurden bei den entsprechenden D/A-Wandlern W2 und Wn die Anschlüsse für die Ausgänge ausgetauscht - siehe jeweils Detail D.

Die Ausgangssignale AS0 bis ASn der D/A-Wandler W0 bis Wn werden zeitgleich aufsummiert und bilden das analoge Ausgangssignal AA.

Das hochfrequente digitale Eingangssignal DE kann bei der vorliegenden Erfindung auch breitbandig ausgestaltet sein.

## Patentansprüche

1. Anordnung zur Digital-Analog-Wandlung eines hochfrequenten digitalen Eingangssignals (DE) in ein trägerfrequentes analoges Ausgangssignal (AA),
- bei der eine Verzögerungseinrichtung (VZ) mindestens ein erstes Verzögerungsglied (VG1) aufweist und weitere Verzögerungsglieder (VG2,...,VGn) dem ersten seriell aufeinanderfolgend nachgeschaltet sind,
- bei der das digitale Eingangssignal (DE) einerseits an einen Eingang des ersten Verzögerungsglieds (VG1) und andererseits an einen Eingang eines ersten D/A-Wandlers (W0) angeschaltet ist,
- bei der das erste Verzögerungsglied (VG1) ausgangsseitig mit einem Eingang eines ihm zugeordneten weiteren D/A-Wandlers (W1) verbunden ist und gegebenenfalls jedes weitere Verzögerungsglied (VG2,...,VGn) ausgangsseitig mit einem Eingang eines dem jeweiligen Verzögerungsglied (VG2,...,VGn) zugeordneten weiteren D/A-Wandlers (W2,...,Wn) verbunden ist,
- bei der alle D/A-Wandler (W0,...,Wn) ausgangsseitig stufenweise derart zusammengefasst sind, dass Ausgangssignale (AS0,...,ASn) aller D/A-Wandler (W0,...,Wn) das analoge Ausgangssignal (AA) bilden, und
- bei der jedem D/A-Wandler (W0,...,Wn) ein spezifischer Koeffizient (k0,...,Kn) und jedem Verzögerungsglied (VG1,...,VGn) eine spezifische Verzögerungszeit (τ1,...,τn) zur Realisierung einer Filtercharakteristik zugeordnet sind.

2. Anordnung nach Anspruch 1, bei der an jedem einzelnen D/A-Wandler (W0,...,Wn) ein identisches Taktsignal (CLK) angeschaltet ist.

3. Anordnung nach Anspruch 2, bei der die den Verzögerungsgliedern (VG1,...,VGn) spezifisch zugeordneten Verzögerungszeiten (τ1,...,τn) einer vollen Taktperiode oder einer Teiltaktperiode des Taktsignals (CLK) entsprechen.

4. Anordnung nach einem der vorhergehenden Ansprüche, bei der die spezifischen Koeffizienten (k0,...,kn) und die spezifischen Verzögerungszeiten (τ1,...,τn) derart gewählt sind, dass eine FIR-Filtercharakteristik realisiert wird.

5. Anordnung nach einem der vorhergehenden Ansprüche, bei der die Verzögerungsglieder (VG1,...,VGn) als mit dem Taktsignal (CLK) getaktete D-Latch ausgebildet sind.

6. Anordnung nach einem der vorhergehenden Ansprüche, bei der die D/A-Wandler (W0,...,Wn) als 1Bit-D/A-Wandler ausgebildet sind.

7. Anordnung nach einem der vorhergehenden Ansprüche, bei der die D/A-Wandler (W0,...,Wn) ausgangsseitig mittels Addiereinrichtungen (AE1,...,AEn) zusammengefasst sind.

8. Anordnung nach einem der vorhergehenden Ansprüche, bei der die den Verzögerungsgliedern (VG1,...,VGn) zugeordneten Verzögerungszeiten (τ1,...,τn) gleich sind.

9. Anordnung nach einem der vorhergehenden Ansprüche, bei der die Ausgangssignale (AS0,...,ASn) der D/A-Wandler (W0,...,Wn) zur Verbesserung der Filterfunktion jeweils eine Mehrfachpulsfolge aufweisen.

10. Anordnung nach einem der vorhergehenden Ansprüche, bei der das digitale Eingangssignal (DE) breitbandig ist.
